Europäisches Patentamt

European Patent Office

Office européen des brevets

(11) Publication number: **0 163 856**
**B1**

# EUROPEAN PATENT SPECIFICATION

(45) Date of publication of patent specification: **23.08.89**

(51) Int. Cl.⁴: **H 01 L 23/48**

(21) Application number: **85104318.2**

(22) Date of filing: **10.04.85**

(54) **Method of making lead frame support for ic chip.**

(30) Priority: **02.05.84 US 606312**

(43) Date of publication of application:
**11.12.85 Bulletin 85/50**

(45) Publication of the grant of the·patent:
**23.08.89 Bulletin 89/34**

(84) Designated Contracting States:
**AT BE DE FR GB IT NL**

(56) References cited:
**EP-A-0 023 165**
**US-A-4 137 546**
**US-A-4 331 831**

(73) Proprietor: **GTE Products Corporation**
**100 West 10th Street**
**Wilmington, DE 19801 (US)**

(72) Inventor: **Gilder, Thomas G., Jr.**
**1169 Fairview Drive**
**York, PA 17403 (US)**
Inventor: **O'Dean, Raymond D.**
**3620 Willow Road**
**Dover, PA 17315 (US)**

(74) Representative: **Patentanwälte Grünecker, Dr.
Kinkeldey, Dr. Stockmair, Dr. Schumann, Jakob,
Dr. Bezold, Meister, Hilgers, Dr. Meyer-Plath
Maximilianstrasse 58
D-8000 München 22 (DE)**

## Description

This invention is related to a method of making a lead frame support for IC chips of the type as disclosed in US—A—4,137,546.

From said prior art document, it is known to secure leads of a lead frame to a ceramic substrate by melting a low melting point glass screen printed on the substrate whereby the ends of the leads are embedded in the glass.

From EP—A—0 023 165, there is known the use of spaced-apart projections to define a slot therebetween. In this prior art document, a lead is secured in that slot so that the leads are precisely positioned with respect to an IC chip provided on a support plate.

As pointed out in the above patents, the lead frames are usually made by stamping or etching metal strips. Where the manufactured quantities are sufficiently great, stamping is preferred because of its lower cost.

As the circuits on the chips become more complex, a greater number of leads per lead frame is required. This complicates the stamping operation. Stamping is carried out in progressive dies; that is, a metal strip is fed through a stamping press having successive punch and die sets at a number of stations, where successive stamping operations are carried out. For example, a lead frame having 68 leads would require about 15 to 20 stamping stations and about 140 to 150 cuts. As the number of required stamping stations and cuts increases, the difficulty in maintaining adequate quality of the stamped lead frames also increases.

This invention can reduce the number of required stamping stations and cuts per lead frame. This is accomplished by not making an entire lead frame out of one integral metal strip, as was done in the prior art. Instead, the lead frame is fabricated from a plurality of individual segments which can be fabricated from the same set of stamping tools. Thus, if two segments are used per lead frame, the number of stamping stations can be about halved and the number of cuts can be reduced even more. And if four segments are used per lead frame, the number of stamping stations and cuts can be reduced an even greater extent. The lead frame is manufactured by assembling the segments with precise positioning, and then securing the segments in a suitable support to maintain said precise positions. An IC chip can then be disposed thereon and electrically connected to the leads.

Reference is made to the co-pending European application No. 85104411 (EP—A—0163081) which relates to a method of making a packaged IC chip.

This invention is particularly concerned with the making of the lead frame support and securing of the lead frame segment thereto. The support has raised spaced apart projections, the spaces between projections being slots in which the leads of the segment are secured.

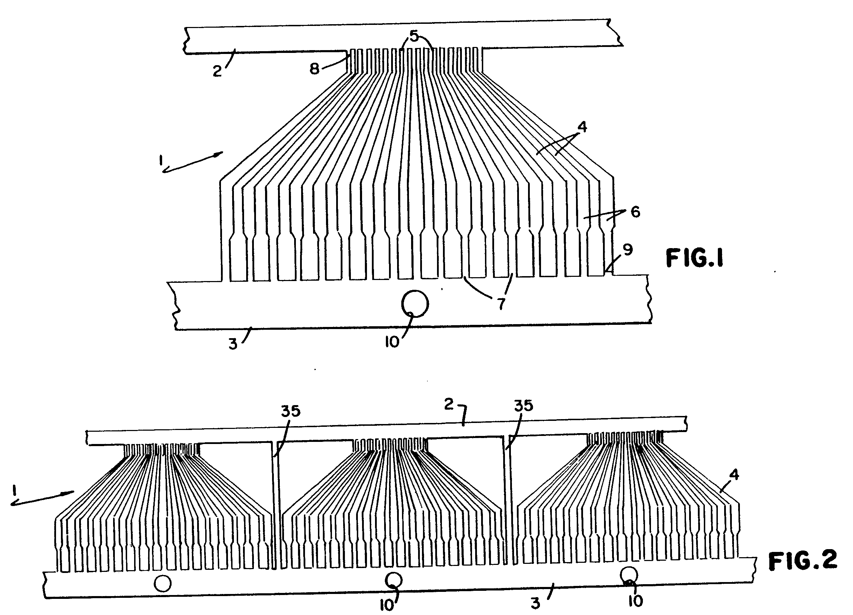

In the drawing, Figure 1 shows a lead frame segment after stamping and Figure 2 shows a strip of such lead frame segments.

Figure 3 is a plan end view of a support for a lead frame.

Figure 4 shows the support with three lead frame segments attached and the fourth ready for attachment.

Figure 5 shows the support with all lead frame segments attached and the leads formed.

Figures 6 and 7 are plan and end views of a cover for the support.

Figure 8 shows the finished chip-containing lead frame package.

In one embodiment, substantially identical lead frame segments 1 were stamped from a long metal strip, as shown in Figure 2. One such segment 1 is shown in Figure 1. In one example, segments 1 were stamped from 0,254 mm (10 mil) copper alloy, specifically, Olin CDA194, and were maintained in strip form by means of continuous rails 2 and 3, as shown in Figure 2. Between segments 1, there were support bars 35 extending from rail 3 to rail 2. Each segment 1 comprised seventeen leads 4. The inner ends 5 of leads 4, which would eventually be electrically connected to an IC chip, were 0,2286 mm (9 mils) wide and space 0,2286 mm (9 mils) apart. The widest parts 6 of leads 4 were inward from the outer ends 7 thereof and were 0,7112 mm (28 mils) wide spaced 0,5588 mm (22 mils) apart. Outer ends 7 were 0,4572 mm (18 mils) wide spaced 0,8128 mm (32 mils) apart. There were score lines 8 and 9 on leads 4 about 0,127 mm (5 mils) from rails 2 and 3. Rails 2 and 3 would eventually be broken off at score lines 8 and 9. There were 1,5748 mm (62 mil), diameter holes 10 in rail 3, which provided means for precise positioning of the lead frame segments during indexing of the copper strip during processing. Rails 2 and 3 were 1,6002 mm (63 mils) and 2,54 mm (100 mils) wide, respectively. The distance between score lines 8 and 9 was 12,192 mm (480 mils).

Support 11 for this example, shown in Figure 3, was made of a high temperature thermoplastic material, specifically a polyetherimide resin made by General Electric Co., Pittsfield, Mass., under the trade name Ultem. In the center of support 11 was a recess 12 in which an IC chip would eventually be disposed. Recess 12 was 8,636 mm (340 mils) square and was recessed 0,2032 mm (8 mils) below surface 13 of support 11. Surrounding recess 12 were seventy-two raised projections 14, eighteen per side. Projections 14 were 0,1778 mm (7 mils) wide by 0,635 mm (25 mils) long by 0,2286 mm (9 mils) high. Spaces 15 between the projections were 3,0734 mm (11 mils) wide. At assembly of segments 1 to support 11, narrow ends 5 of leads 4 would lie on surface 13 in spaces 15 between projections 14. This provides means for accurate co-planar positioning of ends 5 in support 11. On the inner end of each projection 14 was another raised portion 16, measuring 0,1778 mm (7 mils) wide by 0,254 mm (10 mils) long by 0,1524 mm (6 mils) high. Raised portions 16 provided means for securing the leads in spaces 15 by, for example heating and slightly flowing plastic portion 16 over the leads. There was an encircling trough 17 outside the perimeter formed by all the projections 14.

At the periphery of support 11 there were sixty-eight slots 18 in which parts 6 of leads 4 would fit. Slots 18 were formed by projections 29 which were similar to projections 14 but bigger. Projections 29 were 0,508 mm (20 mils) wide by 0,8128 mm (32 mils) long by 0,2286 mm (9 mils) high. Slots 18 were 0,762 mm (30 mils) wide. There were raised portions 30 on the inner ends of projections 29, similar to raised portions 16 on projections 14. Raised portions 30 were 0,508 mm (20 mils) wide by 0,254 mm (10 mils) long by 0,1524 mm (6 mils) high.

In order to permit supports 11 to be processed in existing manufacturing equipment for chip-carrying lead frames, there were rails 19, compatible with said equipment, spaced from each side of support 11 and connected thereto by tie bars 20. Rails 19 were 0,254 mm (10 mils) thick by 3,429 mm (135 mils) wide and were 35,56 mm (1.400 inches) apart from each other. Holes 21 provided means for accurate positioning of the supports during indexing. There were four posts 22 on support 11 for accurate mating of support 11 with cover 23, which was made of the same plastic as support 11.

Cover 23 had a recess 24 to mate with recess 12, and had an additional recess 25 to accommodate projections 14. Cover 23 also had a trough 26 to mate with trough 17, and four holes 27 into which posts 22 fit. There were also two holes 28 connecting with trough 26. After assembly of cover 23 onto support 11, a sealant material could be injected into holes 28 to fill troughs 17 and 26 in order to seal the IC chip from the environment.

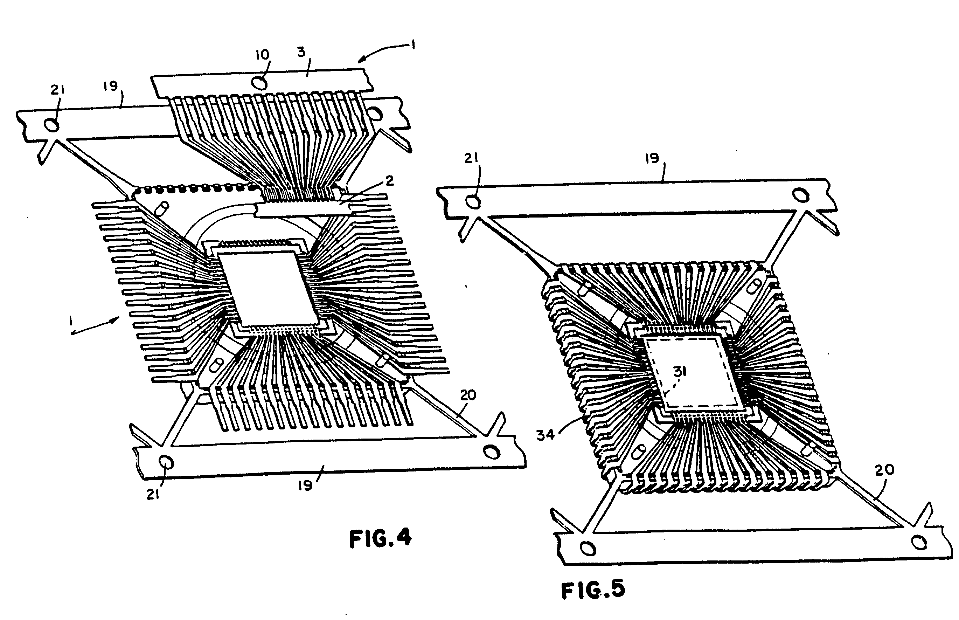

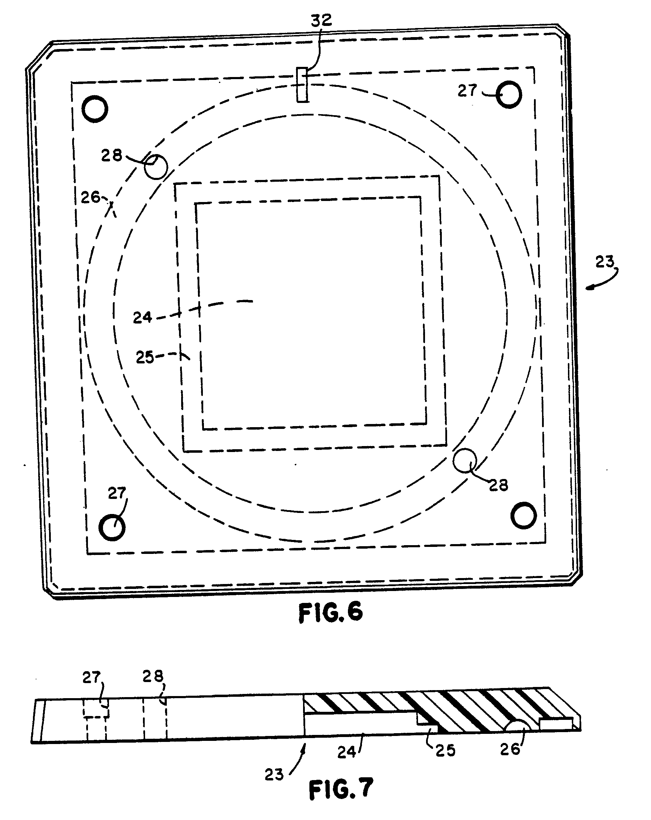

Assembly of the components would proceed as follows. Four lead frame segments 1, with rails 2 and 3 still attached, would be placed on top of support 11, one at a time and one in each quadrant, as shown in Figure 5. Each segment 1, with rails 2 and 3 still attached thereto but with rail 2 having been trimmed sufficiently to fit the space, as shown in Figure 4, would be carefully positioned so that ends 5 lay in spaces 15 and parts 6 lay in slots 18. Pressure would then be applied to segment 1 to ensure that it was flush against surface 13 and then, maintaining the pressure, heat would be applied to portions 16 and 30 to cause them to flow over, and secure in place, ends 5 and parts 6 of leads 4. Rails 2 and 3 would then be broken off at score lines 8 and 9. This process would be repeated for each lead frame segment 1. This construction ensures accurate positioning, with secure attachment, of all sixty-eight leads with excellent co-planarity thereof.

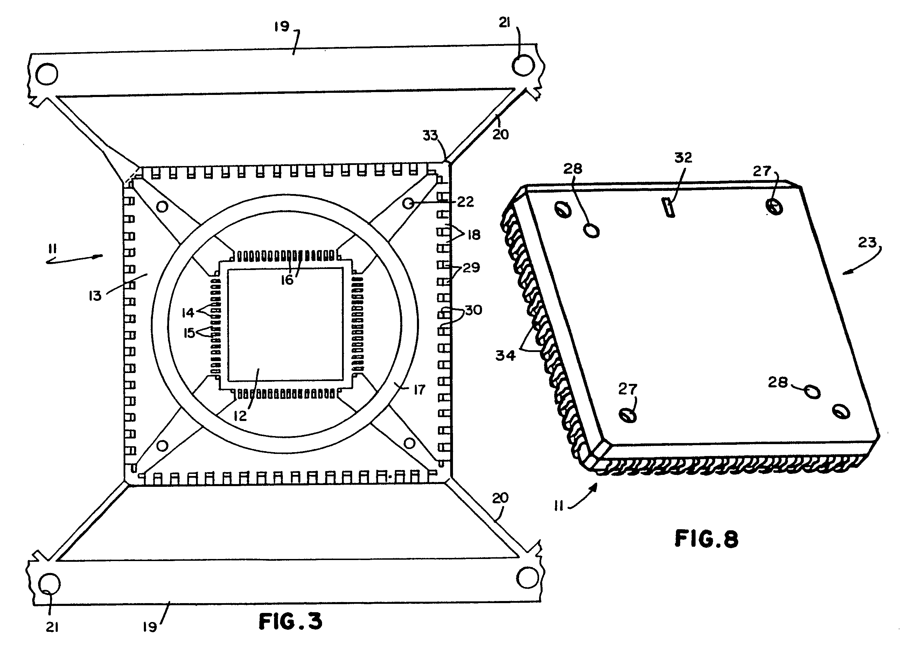

Next, an IC chip 31, shown in dotted lines in Figure 5, would be conventionally attached in the pad area, recess 12, and would be conventionally electrically connected to ends 5 of leads 4. The rail construction of support 11 permits this processing to be performed on existing chip-carrier lead frame processing equipment. An advantage of this invention is that the IC chip and package can now be tested for electrical characteristics, because all sixty-eight leads are now electrically isolated, and repair of electrical connections can be made, if necessary. In the past, such repair could not be made because the leads were not electrically isolated until after packaging. The external ends of leads 4 can now be formed into a desired shape, such as "J" lead shape 34 shown in Figures 5 and 8.

Next cover 23 is placed on support 11, posts 22 fitting into holes 27. Holes 27 are counterbored about half-way through as shown in Figure 7, for example, to 1,0922 mm (43 mils) diameter from 0,8382 mm (33 mils) diameter. Posts 27 extend somewhat in the counterbores of holes 27, thereby providing the means for securing cover 23 to support 11 by heat-flowing the extending upper ends of posts 27, as raised portions 16 and 30 were heat-flowed. Next, a sealant, for example, a silicone gel, is pumped into holes 28 to completely fill troughs 17 and 26 as well as holes 28. The sealant should be sufficiently adherent and flexible, after curing, to maintain a hermetic seal through normal thermal cycling requirements. If desired, assembly of cover 23 and sealing of trough 17 and 28 can be performed in an atmosphere having greater heat dissipation characteristics than air such as helium. This atmosphere will be sealed in the recesses in which chip 31 is disposed. To complete the package, a lead identifier 32 may be used, as shown in Figure 8, and rails 19 and tie bars 20 are removed at score lines 33.

The finished unit, shown in Figure 8, had overall measurements, including formed leads 34, of 25,0952 mm (988 mils) square by 4,445 mm (175 mils) high.

This invention is also applicable to lead frames made other than by stamping, such as etching or chemical forming. Therefore, a significant advantage to the use of segments as per this invention is a substantial reduction in tooling cost.

## Claims

1. A method of making a lead frame comprising the steps of:
preparing a plurality of individual lead frame segments (1) each comprising a plurality of spaced-apart leads (4) the inner ends of which converge; preparing an electrically insulative support (11) having raised spaced-apart projections (14, 29) and a chip pad area, the spaces between the projections (14, 29) defining slots (15, 18); disposing the lead frame segment (1) on the support (11), the leads (4) of the segment being on the support (11), the leads (4) of the segment (19) being disposed in the slots (15, 18); and securing the leads (4) within the slots (15, 18).

2. The method of claim 1, characterized in that the leads (4) are secured in the slots (15, 18) so as to be substantially co-planar.

3. The method of claim 1 or 2, characterized in that the support (11) is made of a thermoplastic material and the leads (4) are secured in the slots by heat flowing said material.

4. The method of one of claims 1 to 4, characterized in that said lead frame segments (1) are secured to the support (11) substantially co-planarly.

5. The method of one of claims 1 to 4, characterized in that the support (11) has a substantially centrally located pad area (12) and has inner spaced-apart projections (14) proximate the pad area (12) and has outer spaced-apart projections (29) proximate the periphery of the support (11), and wherein the leads (4) of the lead frame segments (1) have inner ends (5) and outer ends (7), said inner ends (5) being secured within slots (15) between the inner projections (14) and said outer ends (7) being secured within slots (18) between the outer projections (29).

6. The method of one of claims 1 to 5, characterized in that the leads (4) are secured in the slots (15, 18) by bonding with an adhesive.

**Patentansprüche**

1. Verfahren zur Herstellung einer Leiterplatte, gekennzeichnet durch folgende Schritte:
Herstellen von mehreren einzelnen Leiterplattensegmenten (1), die jeweils mehrere voneinander beabstandete Leitungen (4) aufweisen, deren innere Enden zusammenlaufen, Herstellen einer elektrisch isolierenden Halterung (11) mit erhabenen, voneinander beabstandeten Vorsprüngen (14, 29) und einem Chipkissenbereich, wobei die Abstände zwischen den Vorsprüngen (14, 29) Schlitze (15, 18) begrenzen, Anordnen des Leiterplattensegments (1) auf der Halterung (11), wobei die Leitungen (4) des Segments auf der Halterung (11) aufliegen und die Leitungen (4) des Segments (19) in den Schlitzen (15, 18) angeordnet sind, und Befestigen der Leitungen (4) in den Schlitzen (15, 18).

2. Verfahren nach Anspruch 1, dadurch gekennzeichnet, daß die Leitungen (4) in den Schlitzen (15, 18) so befestigt sind, daß sie im wesentlichen in einer Ebene liegen.

3. Verfahren nach Anspruch 1 oder 2, dadurch gekennzeichnet, daß die Halterung (11) aus einem thermoplastischen Material besteht und daß die Leitungen (4) in den Schlitzen durch Wärmeflie-ßen des Materials befestigt sind.

4. Verfahren nach einem der Ansprüche 1 bis 3, dadurch gekennzeichnet, daß die Leiterplattensegmente (1) an der Halterung (11) im wesentlichen in einer Ebene liegend befestigt sind.

5. Verfahren nach einem der Ansprüche 1 bis 4, dadurch gekennzeichnet, daß die Halterung (11) einen im wesentlichen mittig angeordneten Kissenbereich (12) und innere, voneinander beabstandete Vorsprünge (14) nahe dem Kissenbereich (12) sowie äußere, voneinander beabstandete Vorsprünge (29) nahe dem Rand der Halterung (11) aufweist, und daß die Leitungen (4) der Leiterplattensegmente (1) innere Enden (5) und äußere Enden (7) aufweisen, wobei die inneren Enden (5) in den Schlitzen (15) zwischen den inneren Vorsprüngen (14) und die äußeren Enden (7) in den Schlitzen (18) zwischen den äußeren Vorsprüngen (29) befestigt sind.

6. Verfahren nach einem der Ansprüche 1 bis 5, dadurch gekennzeichnet, daß die Leitungen (4) durch Verbindung eines Klebemittels in den Schlitzen (15, 18) befestigt sind.

**Revendications**

1. Procédé de fabrication d'un cadre d'interconnexion comprenant les étapes suivantes:
préparation d'une pluralité de cadres individuels d'interconnexion (1) comprenant chacun une pluralité de conducteurs séparés (4) dont les extrémités internes convergent;
préparation d'un support électriquement isolant (11) présentant des projections relevées séparées (14, 29), et une zone formant support de puce, les espaces entre les projections (14, 29) définissant des fentes (15, 18);
mise du cadre d'interconnexion (1) sur le support (11), les conducteurs (4) du cadre étant sur le support (11) et disposés dans les fentes (15, 18); et
fixation des conducteurs (4) à l'intérieur des fentes (15, 18).

2. Procédé selon la revendication 1 caractérisé en ce que les conducteurs (4) sont fixés dans les fentes (15, 18) de manière à être substantiellement coplanaires.

3. Procédé selon la revendication 1 ou 2 caractérisé en ce que le support (11) est réalisé dans un matériau thermo-plastique et que les conducteurs (4) sont fixés dans les fentes par traitement à chaud du dit matériau.

4. Procédé selon l'une des revendications 1 à 4 caractérisé en ce que les dits cadre d'interconnexion (1) sont fixés au support (11) de façon substantiellement coplanaire.

5. Procédé selon l'une quelconque des revendications 1 à 4 caractérisé en ce que le support (11) présente une zone (12) formant support de puce substantiellement centrale, qu'il a des projections internes séparées (14) au voisinage de la zone formant support de puce (12), qu'il a des projections externes séparées (29) au voisinage de la périphérie du support (11), et que les conducteurs (4) des cadres d'interconnexion (1) présentent des extrémités internes (5) et des extrémités externes (7), les dites extrémités internes (5) étant fixées à l'intérieure de fentes (15) entre les projections internes (14), et les dites extrémités externes (7) étant fixées à l'intérieur de fentes (18) entre les les projections externes (29).

6. Procédé selon l'une des revendications 1 à 5, caractérisé en ce que les conducteurs (4) sont fixés dans les fentes (15, 18) par collage au moyen d'un adhésif.

FIG.1

FIG.2

FIG.5

FIG.4

FIG. 6

FIG. 7

FIG.8

FIG.3

4